Europäisches Patentamt

European Patent Office

Office européen des brevets

(19)

(11) **EP 0 922 999 A2**

(12) **EUROPEAN PATENT APPLICATION**

(43) Date of publication:
16.06.1999 Bulletin 1999/24

(51) Int. Cl.$^6$: **G03F 7/20**

(21) Application number: 98122948.7

(22) Date of filing: 03.12.1998

(84) Designated Contracting States:
**AT BE CH CY DE DK ES FI FR GB GR IE IT LI LU MC NL PT SE**
Designated Extension States:
**AL LT LV MK RO SI**

(30) Priority: 12.12.1997 JP 36274297

(71) Applicant: **NIKON CORPORATION**
**Tokyo (JP)**

(72) Inventor:
**Tanitsu, Osamu**
**c/o Nikon Corp. (Intell. Prop.Hdq.)**
**Tokyo (JP)**

(74) Representative:
**Viering, Jentschura & Partner**
**Postfach 22 14 43**
**80504 München (DE)**

(54) **Illumination optical system and illumination method**

(57) An illumination optical system and related apparatus and methods for maintaining illumination efficiency at an object plane. The illumination apparatus (104) comprises a light source (110) for generating a light beam (111), a first optical integrator (114) having an incident surface (114i) and an exit surface (114s), and a second optical integrator (120) having an incident surface (120i) and an exit surface (120s). An aperture stop (122) is arranged proximate the second optical integrator exit surface. A relay lens system (118) is disposed between the first and second optical integrators, and includes a first lens group (118a) with a focal length f1 and a second lens group (118b) with a focal length f2, wherein f1 ≠ f2. At least one of the lens groups is axially moveable such that the relay lens system has a variable focal length. The relay lens system is designed such that the incident surfaces are substantially conjugate and the exit surfaces are substantially conjugate. The apparatus further comprises a condenser lens for condensing light from the second optical integrator onto the object plane. Illumination intensity at the object plane is substantially maintained even when the aperture stop diameter is changed (i.e., the illumination coherence is changed), by adjusting the focal length of the relay lens system to illuminate a region on the incident surface of the second optical integrator corresponding to the aperture diameter.

FIG. 3a

EP 0 922 999 A2

## Description

### Field of the Invention

The present invention relates to an illumination optical system, and more particularly pertains to an illumination optical system and related methods for maintaining illumination efficiency.

### Background of the Invention

Projection exposure apparatus are presently employed in the manufacturing of devices having fine structures, such as VLSI (very large scale integrated) circuits and LCD displays. In the quest for improving resolution and imaging performance of such apparatus, various approaches have been taken, such as increasing the numerical aperture of the projection lens included in the apparatus, or decreasing the wavelength of exposure light.

Another approach is to control the illumination so as to achieve the proper balance between resolution and contrast with respect to the pattern being imaged. One such approach is described in U.S. Patent No. 5,392,094 ("the '094 patent"), which patent is incorporated by reference herein, and which is briefly described immediately below.

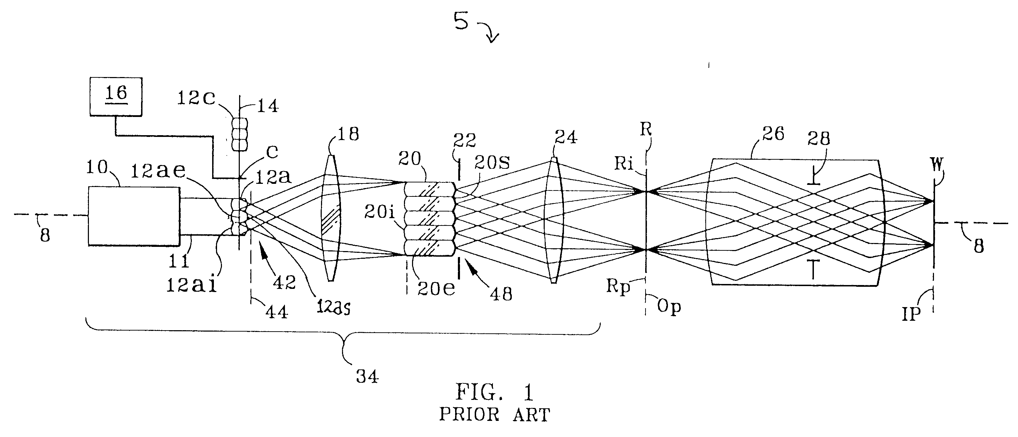

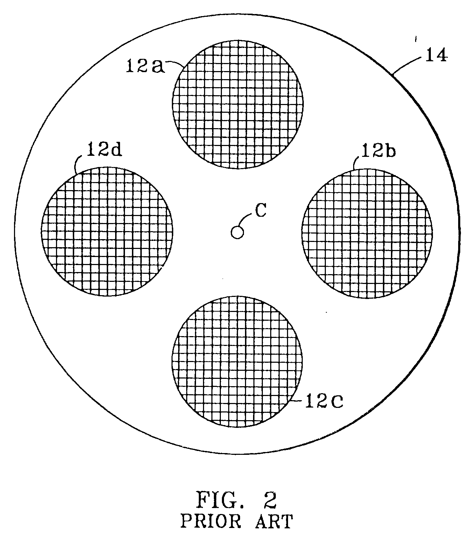

With reference to FIG. 1, there is shown the '094 patent prior art projection exposure apparatus 5 comprising, in order along an optical axis 8, a light source 10 for generating a light beam 11, and a first fly's eye lens 12a having an incident surface 12ai and comprising elements 12e. First fly's eye lens 12a serves as an optical integrator and is attached to an optical integrator turret 14 comprising additional fly's eye lenses 12b-12d (see FIG. 2). Turret 14 is controlled by a drive system 16 connected thereto to rotate the turret about its center C so as to remove one fly's eye lens (e.g.,12a) from the path of light beam 11 and replace it with another (e.g., 12c).

Apparatus 5 further comprises a relay lens system 18, a second fly's eye lens 20 comprising elements 20e and having an incident surface 20i and an exit surface 20s, an aperture stop 22 located proximate exit surface 20s, and a condenser lens 24. Relay lens system 18 is arranged so as to make incident surfaces 12ai and 20i conjugate. Adjacent condenser lens 24 is a projection lens 26 with an object plane OP, a pupil (i.e., aperture stop) 28, and an image plane IP. Aperture stop 28 defines the numerical aperture $NA_P$ of projection lens 26. The elements from light source 14 to condenser lens 24 inclusive constitute an illumination optical system 34. A reticle R having an incident surface Ri is removably arranged at a reticle plane RP between condenser lens 24 and projection lens 26 that is proximate object plane OP. (In FIG. 1, RP and OP are co-planar.) A photosensitive substrate (e.g., a photoresist-coated wafer) W is arranged conjugate to reticle R on the opposite side of projection lens 26 at image plane IP.

With continuing reference to FIG. 1, light beam 11 from light source 10 is incident first fly's eye lens 12a at incident surface 12ai. First fly's eye lens 12a forms a plurality of point images (i.e., secondary light sources) 42 at a first image plane 44 immediately downstream from the first fly's eye lens. Light from each of secondary light sources 42 is then imaged so as to overlap and cover substantially the entire incident surface 20i of second fly's eye lens 20, which then forms tertiary light sources 48 at aperture stop 22. Condenser lens 24 then images the light from each of tertiary light sources 48 in an overlapping fashion over substantially the entire incident surface Ri of reticle R. The process of forming secondary and tertiary light sources 42 and 48 and then re-distributing the light from each of these individual light sources over an entire surface serves to uniformize the illumination (i.e., intensity) distribution of the light incident reticle R.

However, a shortcoming of illumination optical system 34 of projection exposure apparatus 5 is that the design of first fly's eye lens 12a is tied to the size (i.e., diameter) of aperture stop 22. For example, when aperture stop 22 is stopped down to decrease the illumination numerical aperture $NA_I$ to reduce the illumination coherence (defined as $\sigma = NA_I / Na_P$), the existing first fly's eye lens 12a needs to be replaced with another first fly's eye lens having a design compatible with the new aperture stop size to maintain illumination intensity and efficiency. For instance, with reference to FIG. 2, first fly's eye lens 12a is replaced with first fly's eye lens 12b having the design properties corresponding to the new value of $NA_I$. This is accomplished by rotating optical integrator turret 14 by drive system 16. Alternatively, the existing relay lens system needs to be replaced with another relay lens system having a design (e.g., focal length) compatible with the new aperture stop size.

Thus, to cope with the wide variety of possible changes in the illumination numerical aperture $NA_I$, (i.e., changes in the diameter of aperture stop 22) a large number of first fly's eye lenses or relay lens systems need to be available to serve as replacements. In addition, an automated first fly's eye lens changing system for changing the first fly's eye lens and/or a relay lens system changing system is required. These requirements add tremendously to the cost and complexity of the projection exposure apparatus.

### Summary of the Invention

The present invention relates to an illumination optical system, and more particularly pertains to an illumination optical system and related methods capable of maintaining illumination efficiency.

It is a first objective of the present invention to provide an illumination optical system capable of maintaining a fixed illumination efficiency with a small number of possible first optical integrators and a variable-diameter aperture stop. A second objective is to provide a projection exposure apparatus with such an illumination optical system. A third objective is to provide a method of illuminating an object at substantially fixed illumination intensity while varying the illumination coherence. A fourth objective is to provide a semiconductor device manufacturing method (i.e., a method of patterning a photosensitive substrate) which allows the illumination intensity incident the object (e.g., a reticle) to be substantially maintained, while the illumination coherence is varied. A sixth objective is to provide an optical integrator system.

According to the present invention, the types of optical integrators can be kept to a minimum cost reductions can be achieved, and illumination can be performed without a drop in throughput. This is accomplished by providing an illumination optical system capable of minimizing the reduction in illumination intensity even with an aperture stop having various possible diameters, without regard to the different types of optical integrators employed.

To achieve the objects of the present invention, a first aspect of the present invention is an illumination optical system for illuminating an object plane. The system comprises, along an optical axis, a light source for generating a light beam, a first optical integrator having an incident surface and a first exit surface, and a second optical integrator having an incident surface and an exit surface. A relay lens system is disposed between the first and second optical integrators. The relay lens system comprises a first lens group with a focal length f1 and a second lens group with a focal length f2, wherein f1 ≠ f2. At least one of the lens groups is axially moveable such that the relay lens system has a variable focal length. The relay lens system is designed such that the incident surfaces are substantially conjugate and the exit surfaces are substantially conjugate. A condenser lens proximate the second optical integrator exit surface condenses light from the second optical integrator onto the object plane.

A second aspect of the invention is an illumination optical system as described above, wherein TL is the distance between the exit surface of the first optical integrator and the incident surface of the second optical integrator, and wherein the following condition is satisfied:

$$TL/f1 \geq 0.8.$$

A third aspect of the invention is an illumination optical system as described above, wherein the first optical integrator has a variable focal length.

A fourth aspect of the invention is an illumination optical system as described above, wherein the first optical integrator is axially moveable.

A fifth aspect of the invention is a projection exposure apparatus, which includes the illumination system as described above, and a projection lens arranged between the object plane and the photosensitive substrate.

A sixth aspect of the invention is a method of substantially maintaining illumination intensity at an object plane while changing the illumination coherence. The method comprises the steps of first relaying light from each of a plurality of secondary light sources to be incident over a first region of an incident surface of a second optical integrator using a variable focal length relay lens system, thereby forming a plurality of tertiary light sources within an aperture stop having a first diameter. Then, the next step is condensing light from each of the tertiary light sources to be incident the object plane at a predetermined illumination intensity. The next step is changing the illumination coherence by changing the diameter of the aperture stop to a second diameter. The last step is varying the focal length of the relay lens system to illuminate a second region of the incident surface of the second optical integrator corresponding to the second diameter, thereby substantially maintaining the predetermined intensity at the object plane.

**Brief Description of the Drawings**

FIG. 1 is a schematic optical diagram of the configuration of a prior art projection exposure apparatus with a prior art illumination optical system;

FIG. 2 is a front view of the prior art optical integrator turret of the projection exposure apparatus of FIG. 1;

FIGS. 3a-3b are schematic optical diagrams of an exposure apparatus comprising a first embodiment of the illumination optical system of the present invention;

FIGS. 4a-4b are isometric views of a section of the illumination optical system of the exposure apparatus of FIG. 3;

FIG. 5 is a face-on view of the exit surface of the second fly's eye lens in the illumination optical system of FIGS. 4a-4b, with various aperture stop diameters shown;

FIGS. 6a-6b are graphs of the intensity ratio ($I_R$) vs. aperture stop diameter D, for various types of first fly's eye lenses;

FIG. 7 is a schematic diagram showing the configuration of a section of the illumination optical system of the exposure apparatus of FIGS. 3a-3c;

FIG. 8 shows a preferred embodiment of a first fly's eye lens having a variable focal length;

FIG. 9 is a schematic optical diagram of a preferred embodiment of the illumination optical system of the present invention, which includes a control apparatus for controlling the exchange apparatus, the focal length of the relay optical system, and the aperture stop diameter; and

FIGS. 10a-10b are front views of a set of a plurality of first fly's eye lenses in the form of a turret (10a) and a cartridge (10b).

## Detailed Description of the Invention

The present invention relates to an illumination optical system, and more particularly pertains to an illumination optical system and related methods capable of maintaining a substantially fixed illumination efficiency.

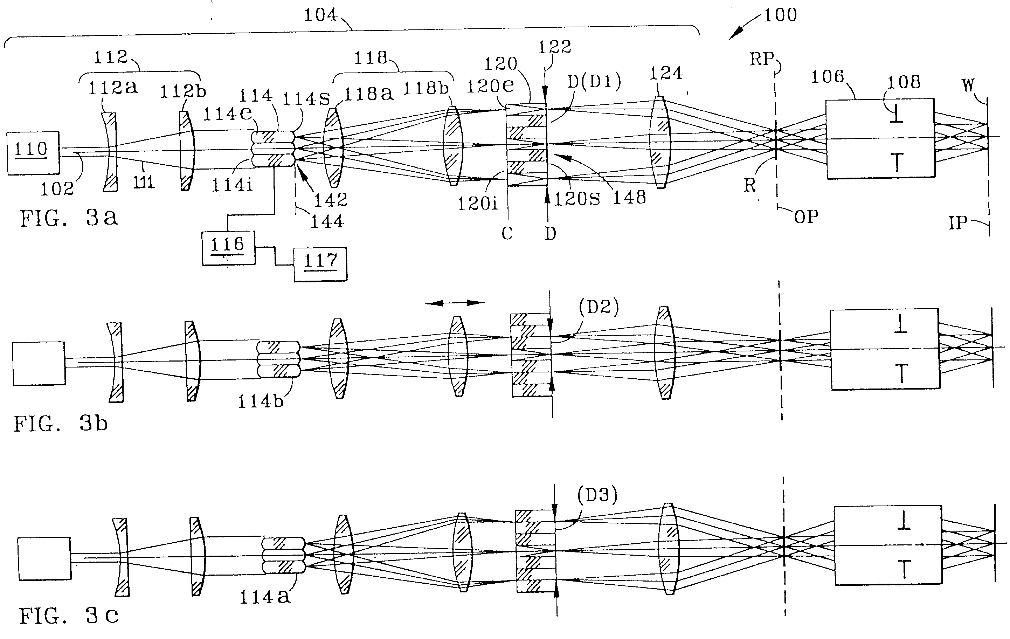

With reference to FIGS. 3a-3c, projection exposure apparatus 100 comprises, in order along an optical axis 102, an illumination optical system 104 according to the present invention, and a projection lens 106 with an object plane OP, a pupil (aperture stop)108, and an image plane IP. A reticle plane RP for accommodating a reticle R exists between illumination optical system 104 and projection lens 106 and is substantially co-planar with object plane OP (FIGS. 3a-3c show RP and IP as co-planar).

Illumination optical system 104 comprises, in order along optical axis 102, a light source 110 for generating a light beam 111. Light source 110 may be, for example, a KrF excimer laser for generating light having a wavelength of 248 nm, an ArF excimer laser for generating light having a wavelength of 193 nm, or an $F_2$ laser for generating light having a wavelength of 157 nm. Alternatively, light source 110 may be a lamp, such as a halogen lamp. Adjacent light source 110 is a beam expander system 112 comprising a concave lens 112a and a convex lens 112b, and a first fly's eye lens 114 comprising a plurality of lens elements 114e and having an incident surface 114i and an exit surface 114s. First fly's eye lens 114 serves as a first optical integrator. First fly's eye lens 114 is removably arranged adjacent beam expander system 112 such that one of a plurality of first fly's eye lenses having different focal lengths ff1 and constituting a set 117 of such lenses (e.g., 114a and 114b of FIGS. 3a and 3b) can replace the fly's eye lens residing in light beam 111. Replacement/exchange of fly's eye lens 114 is accomplished via an exchange apparatus 116 in communication with set 117 of fly's eye lenses 114. Exchange apparatus 116 may be a drive system, and set 117 may be a turret or other like member comprising different fly's eye lenses, as discussed further below.

Further included in illumination optical system 104 is a relay lens system 118 comprising first and second lens groups 118a and 118b, each of which may comprise one or more optical elements, and a second fly's eye lens 120 comprising a plurality of lens elements 120e and having an incident surface 120i and an exit surface 120s. Second fly's eye lens 120 serves as the second optical integrator. Relay lens system 118 is designed and arranged such that incident surfaces 114i and 120i of first and second fly's eye lenses 114 and 120, respectively, are conjugate, and exit surfaces 114e and 120e of first and second fly's eye lens 114 and 120, respectively, are conjugate. Also, at least one of lens groups 118a and 118b is axially moveable such that the focal length $f_r$ of relay lens system 118 is adjustable, as described below.

Adjacent fly's eye lens 120 proximate exit surface 120s is an aperture stop 122 with an aperture diameter D. FIGS. 3a-3c illustrate three different aperture diameters D1, D2, D3, respectively. Aperture stop 122 is configured such that other aperture stops having different apertures can be exchanged with the existing aperture stop, as needed. Alternatively, aperture stop 122 has a diameter D that is variable, so that a single aperture can be set to have different aperture diameters. Adjacent aperture stop 122 is a condenser lens 124 designed such that incident surface 120i is conjugate (or nearly so) to object plane OP and image plane IP, and exit surface 120e are conjugate (or nearly so) to pupil (i.e., aperture stop) 108 of projection lens 106.

To perform an exposure of a photosensitive substrate with projection exposure apparatus 100, reticle R is arranged at reticle plane RP, and a photosensitive substrate (e.g., a photoresist-coated wafer) 134 is arranged conjugate to reticle R on the opposite side of the projection lens proximate image plane IP.

With continuing reference to FIGS. 3a-3c, the operation of projection exposure apparatus 100 to perform an exposure of a photosensitive substrate is now described. Light beam 111 emanating from light source 110 and having, for example, a first rectangular beam cross section, is transformed to having a second rectangular beam cross section by beam expander system 112. Light beam 111 is then incident first optical integrator 114 at incident surface 114i. A plurality of secondary light sources (i.e., a plurality of secondary light source images) 142 are formed at a first image plane 144 located immediately downstream from fly's eye lens 114. The number of secondary light sources 142 corresponds to the number of lens elements 114e included in first fly's eye lens 114.

Light from each of secondary light sources 142 is imaged by relay lens system 118 so as to overlap and cover substantially a given region on incident surface 120i of second fly's eye lens 120. The latter then forms a plurality of tertiary light sources (i.e., a plurality of tertiary light source images) 148 at aperture stop 122. The number of tertiary light sources corresponds to the product of the number of lens elements 114e and 120e respectively constituting first and second fly's eye lenses 114 and 120.

At this point, the type and size (i.e., diameter D) of aperture stop 122 can be selected to provide the desired illumination coherence $\sigma$ to adjust the resolution and depth of focus of projection exposure apparatus 100. For example, different aperture diameters may be selected for different reticles R having different patterns. As mentioned above and discussed in greater detail below, any one of number of different aperture sizes may be provided for aperture 122.

Light from each of tertiary light sources 148 formed at aperture stop 122 is then condensed by condenser lens 124 so as to overlap and cover reticle R over a region which contains a predetermined pattern (not shown). In this manner, the pattern of reticle R is uniformly illuminated and projected (exposed) onto photosensitive substrate W by projection lens 106. In the absence of reticle R, an image of aperture stop 122 is formed at pupil (aperture stop) 108.

Photosensitive substrate (i.e., wafer) W exposed and patterned using the photolithography process and projection exposure apparatus described above next undergoes several processing steps. These steps include, in order, a develop process for developing the photosensitive medium (e.g, photoresist) on the substrate, an etch process for removing undeveloped photoresist, and a photoresist elimination process for eliminating unneeded photoresist after the etching process. The processing of photosensitive substrate W is typically completed after repeating the exposure, etching and resist elimination processes steps for different predetermined reticle patterns. Upon completing wafer processing, various additional processes are performed in making a device. These additional processes include dicing the wafer into its constituent printed circuits to create chips, a bonding step that assigns wiring and the like to each chip, and then packaging each chip. Ultimately, semiconductor devices such as VLSI circuits, microprocessors and memory are manufactured. In similar fashion, other types of semiconductor devices, like liquid crystal display devices, thin-film magnetic heads, and detectors (e.g., charge-coupled devices, or "CCDs" and the like) are manufactured.

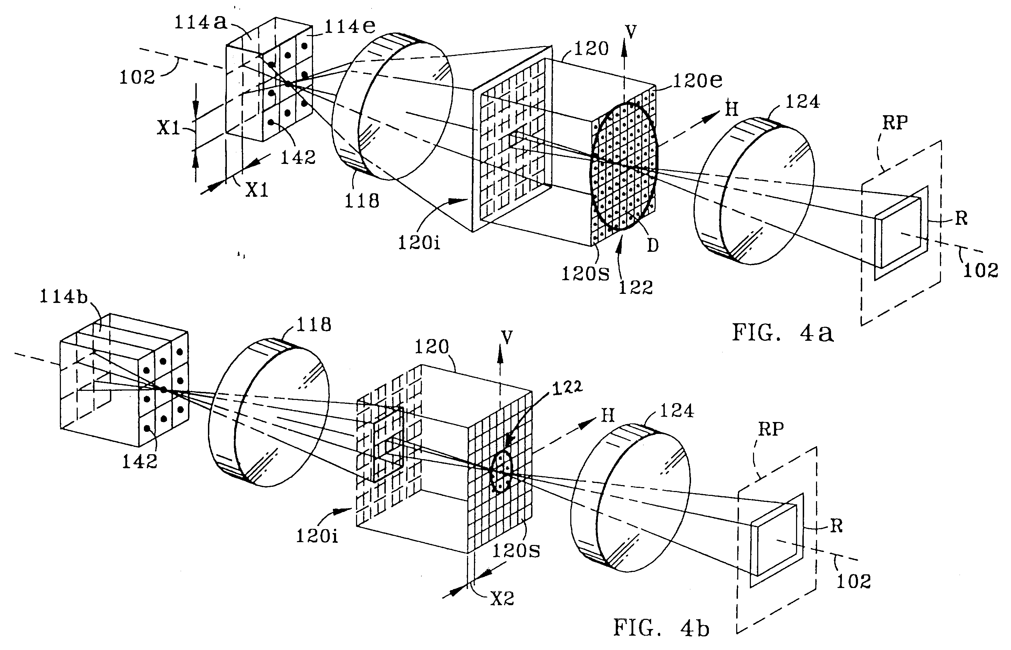

The operation of illumination optical system 104 is now described in further detail. With continuing reference to FIGS. 3a-3b and also to FIGS. 4a-4b. Exchange apparatus 116 selects from set 117 the appropriate fly's eye lens 114 corresponding to aperture diameter D of aperture stop 122 and inserts the lens into light beam 111. The result is that the illumination intensity at reticle plane RP (or object plane OP) is maximized.

Also, in relay lens system 118, at least one-of lens groups 118a and 118b is made moveable so that focal length $f_r$ of the relay lens system is variable, as mentioned above. This allows the size of the illuminated region on incident surface 120i of second fly's eye lens 120 to be adjusted. The size of this illuminated region is adjusted by selecting a first fly's eye lens 114 having a focal length ff1, and then setting the focal length $f_r$ of relay lens system 118 accordingly so as to illuminate a region of a given area on incident surface 120i corresponding to the particular aperture diameter D. This allows the illumination intensity at reticle plane RP (object plane OP) to be maximized, as described further below.

The above-described operation of the present invention is now further explained more quantitatively. With continuing reference to FIGS. 4a-4b, an example fly's eye lens 114a comprises lens elements 114e having a square cross-section of length x1 and a focal length ff1. In practice, lens elements 114e could, of course, have other cross-section shapes, such as rectangular or polygonal. To maintain the illumination intensity on reticle R at a high level, it is preferred that the following inequality be satisfied:

$$x1 \cdot f_r/ff1 \geq D. \tag{1}$$

Within the range that satisfies inequality (1), the illumination intensity on reticle R is maintained at correspondingly higher levels if the value of the left side of the inequality is made as close as possible to the value of aperture diameter D on the right side.

Second fly's eye lens 120 also comprises a plurality of lens elements 120e having, for example, a square cross-section of length x2. If n is the number of elements within area D of aperture stop 122 along horizontal axis H or vertical axis V (assuming a circular aperture), the following inequality holds:

$$x1 \cdot f_r/ff1 \geq n \cdot x2 \geq D. \tag{2}$$

Now let N be the total element number of elements along the vertical axis V or the horizontal axis H of fly's eye lens 120 (assuming a square geometry). Because second fly's eye lens 120 has left-right symmetry, the possible number of lens elements 114e on a side constituting fly's eye lens 114 is N/2 if N is even, and (N-1)/2 if N is odd. However, with the present invention, the reduction of the illumination intensity on reticle R can be kept to a minimum almost without regard to the aperture diameter D at aperture stop 122. In the case of N = 10 for example, 10/2 = 5 "types" (where each type corresponds to the number of lens elements 114e on aside) of first fly's eye lenses 114 are needed if a minimum n = 2 is to be used (i.e., the five types correspond to n = 2, 4, 6, 8 and 10).

If N = 10, then to entirely fill the largest aperture diameter D, it is necessary that ten lens elements 120e on a side, as in $10 \cdot x2$, be used even if, in theory, the number of lens elements necessary is nine. This is because with nine lens elements 120e, complete secondary light source images 142 (or tertiary light source images 148) cannot be formed, and unevenness in illumination intensity arises.

FIGS. 4a-4b show the case for N = 9. In FIG. 4a, aperture diameter D of aperture stop 122 is filled with n = 9 elements along both the horizontal and vertical axes H and V. Accordingly, a predetermined first fly's eye lens 114a is selected and, furthermore, focal length $f_r$ of relay lens system 118 is adjusted so that n = 9 elements completely fill aperture stop 122.

With reference now to FIG. 4b, the diameter D of aperture stop 122 is smaller and is filled with only n = 3 of the N =9 total elements. If focal length $f_r$ of relay lens system 118 is the same as in FIG. 4a, then first fly's eye lens 114a must be replaced by first fly's eye lens 114b so that the light from each secondary light source 142 is imaged onto a region on incident surface 120i of second fly's eye lens 120 corresponding to n = 3 elements (i.e., an area of 9 elements total).

In this manner, if the total number of elements N is large, the possible number of first fly's eye lenses 114 (e.g., 114a, 114b, etc.) that can be used increases accordingly. However, where n < N, the possible types of first fly's eye lens is reduced and limited in number. With regard to the illuminated region on incident surface 120i of second fly's eye lens 120 when n = 3, the value of $x1 \cdot f_r/ff1$ is made to approach as closely as possible the value of $n \cdot x2$ or the value of D by varying focal length $f_r$ in the above inequality (2). In this manner, the illumination intensity on reticle R is maintained at a high level.

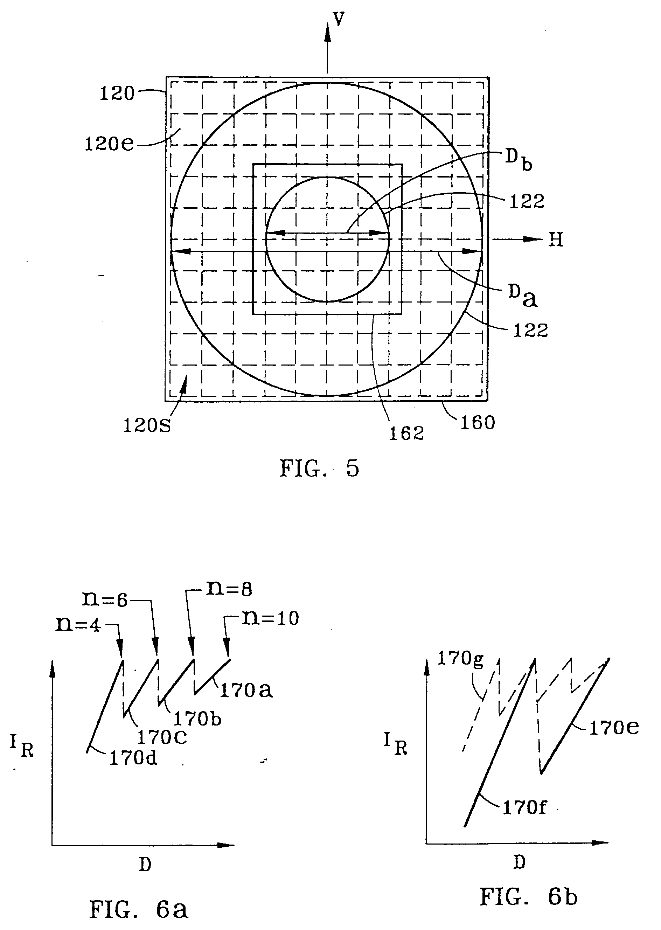

The above principle is now explained in even greater detail with reference to FIG. 5. In the Figure, lens elements 120e are indicated by broken lines. Illumination regions 160 and 162 are formed on incident surface 120i by first fly's eye lenses 114a and 114b, respectively, and appear on exit surface 120s, as shown. Aperture stop 122 has aperture diameters $D_a$ (large) and $D_b$ (small), respectively.

With reference again also to FIGS. 4a-4b, ten second fly's eye lens elements 120e (shown as being a square) are arranged along the vertical V and horizontal H (i.e., N=10). If the largest aperture diameter is $D_a$ and the smallest is $D_b$, then the diameters therebetween can be set freely. The maximum number of lens elements 114e on a side of fly's eye lens 114 that can be encompassed by aperture stop 122 is N=10 because second fly's eye lens 120 has ten elements on a side (N = 10). The minimum number n of elements 140e encompassed by aperture 122 is, for practical purposes, four on a side (N=4) to maintain a high illumination efficiency when the size of the aperture stop is variously changed. Thus, four types, in total, of first fly's eye lens 114 (i.e., 114a - 114d) are needed if the number of elements 114e on a side include n = 4, 6, 8 and 10.

With reference now to FIGS 6a-6b, the illumination intensity ratio $I_R$ (in percent) vs. the aperture diameter D is plotted for each of the four possible types of first fly's eye lenses 114. If the illumination intensity ratio $I_R$ is a maximum of 100% and the aperture diameter D of (circular) aperture stop 122 encompasses along its diameter ten lens elements 120e of second fly's eye lens 120 (i.e., n = 10), then the appropriate first fly's eye lens 114 is, for example, lens 114a. In this case, light from light source 110 passes through fly's eye lens 114a and illuminates, via relay lens system 118, a region on incident surface 120i corresponding to n = 10.

For 8 < n < 10, first fly's eye lens 114a is still employed. In other words, light from light source 110 still illuminates a region on incident surface 120i corresponding to n = 10, just as above. However, aperture 122 is now stopped down, so that a portion of the light incident exit surface 120s from incident surface 120i is blocked. Accordingly, during the interval 8 < n < 10, the illumination intensity ratio decreases, as indicated by curve 170a of FIG. 6a.

Next, if aperture stop 122 is changed to encompass eight elements along its diameter D (i.e., n = 8), the illumination intensity on reticle R becomes identical to the case of n = 10 by replacing existing fly's eye lens 114 (e.g., 114a) with a first fly's eye lens 114 (e.g., 114b) designed to illuminate incident surface 120i over a region corresponding to n = 8. For 6 < n < 8, the same decrease in illumination intensity occurs as that for intermediate value n = 9, indicated by curve 170b. This effect repeats for the remaining values of n, and the intervals in-between, as indicated by curves 170c and 170d.

Having to provide and keep on hand a large number of first fly's eye lenses 114 to maintain the illumination intensity for different aperture diameters is very costly, takes up valuable space, and adds to the complexity of the projection exposure apparatus. However, if only two first fly's eye lenses are provided, for example a ten-element type (i.e., 10x10) and a six-element type (i.e., 6x6), then the illumination intensity in the intermediate aperture diameters D corresponding to n = 4 and n = 8 decreases. This effect is indicated by curves 170e and 170f.

Where only two types of first fly's eye lenses 114 are provided (e.g., 114a and 114b), an illumination ratio of $I_R$ of 100% is obtained only where the fly's eye lenses "match" the corresponding aperture diameters (e.g., $D_a$ and $D_b$). Nevertheless, if an aperture stop 122 having a diameter $D_c$ is provided (or if aperture diameter D is variable and set to $D_c$) a reduction in the illumination intensity is typically unavoidable, regardless of whether first fly's eye lens 114a or 114b is used.

As shown in FIG. 6b, the present invention eliminates this reduction in intensity by providing relay lens system 118, comprising first lens group 118a and second group lens system 118b (see FIG. 1), with at least one of these lens groups being axially moveable such that focal length $f_r$ is continuously variable. This variable focal length allows first fly's eye lens 114 to illuminate the appropriate region on incident surface 120i of second fly's eye lens 120 to compensate for a change in aperture diameter D of aperture stop 122. Accordingly, the same $I_R$ vs. D curves 170g (FIG. 6b) as for the case where numerous first fly's eye lenses 114 are prepared (FIG. 6a) is obtained, even with only two types of first fly's eye lenses.

For example, if N=20, then two types of first fly's eye lenses 114 need only be prepared: one for n = 20 (e.g., 114a) and one for n = 10 (e.g., 114b). This allows for the intermediate values of n (e.g., n = 12, 14, 16, 18) to be covered by adjusting focal length $f_r$ of relay lens system 118.

Thus, to summarize, with reference again to exposure apparatus 100 of FIGS. 3a-3c, light source 110 generates light beam 111. The latter is expanded by beam expander system 112 and illuminates incident surface 114i of first fly's eye lens 114, which forms secondary light sources 142. Light from each of secondary light sources 142 is imaged by relay lens system 118 to cover a region (not shown) on incident surface 120i corresponding to a given number of lens elements 120e encompassed by aperture diameter D of aperture stop 122. If the aperture diameter D of aperture stop 122 is changed, then the focal length $f_r$ of relay lens system 18 is changed to illuminate the corresponding region on incident surface 120i. Incident surface 114i of first fly's eye lens 114 and incident surface 120i of second fly's eye lens 120 are conjugate. Further, exit surfaces 114s and 120s are conjugate. Fly's eye lenses 114 and 120 divide light beam 111 into a plurality of light source images, the number of which is the product of the number of elements constituting each fly's eye lens. These tertiary light source images 148 are formed proximate exit surface 120s of fly's eye lens 120, at the location of aperture stop 122. Each one of the plurality of tertiary light source images 148 formed at aperture stop 122 is expanded and imaged in overlapping fashion by condenser lens 124 to illuminate reticle R. In so doing, a pattern is transferred onto wafer W, and a semiconductor device is manufactured.

In the above described embodiments of the present invention, the illumination region (field) on reticle R is taken as square, for the sake of explanation. In practice, this region may also be rectangular, in which case first fly's eye lens 114 is overall rectangular, similar to the region to be illuminated, and second fly's eye lens 120 is rectangular. If will be apparent to one skilled in the art that various combinations of fly's eye lens element shapes can be employed in the present invention in creating a variety of field shapes.

Working Examples

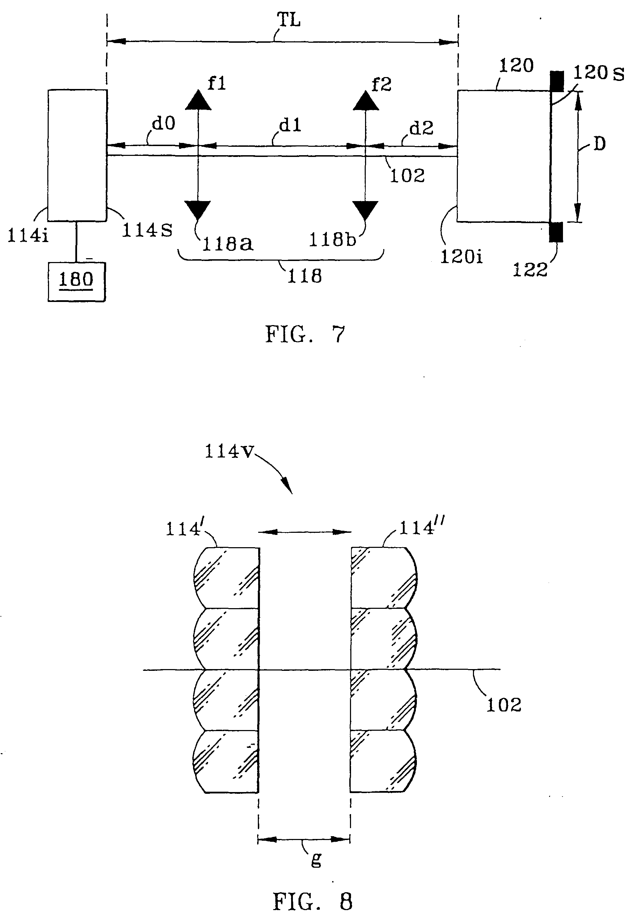

Next, Working Examples of the present invention are explained referencing FIGS. 7-9. With reference now to FIG. 7, the focal length of first lens group 118a is f1, and the focal length of second lens group 118b is f2. The distance between exit surface 114s and first lens group 118a is d0, the distance between the first lens group and second lens group 118b is d1, the distance between the second lens group and incident surface 120i of second fly's eye lens 120 is d2, and the overall length from exit surface 114s to incident surface 120i is TL. Accordingly, TL = d0 + d1 + d2.

The telecentricity T of the system is derived by the expressions below, wherein the back focal length dBF of the system is fixed.

$$d2 = f2 + f2^2/(d1 - f1 - f2) \tag{3a}$$

$$f_r = f1 \cdot f2/(f1 + f2 - d1) \tag{3b}$$

$$d0 = TL - d1 - d2 \tag{3c}$$

$$X_a = -f1 - f1^2/(d0 - f1) \tag{3d}$$

$$X_b = -f2 - f2^2/(X + d1 - f2) \tag{3e}$$

$$T = D/2X_b \tag{3f}$$

In expressions (3a) - (3f), $X_a$ is the virtual pupil position of first lens group 118a, and $X_b$ is the virtual pupil position of second lens group 118b.

Table 1, below, sets forth calculations for Working Example 1 using expressions (3a) - (3f).

## TABLE 1 - Design Values for Working Example 1

| TL | 380 |
|---|---|
| f1 | 370 |
| f2 | 310 |

| d1 | $f_r$ | d2 | d0 | $X_a$ | $X_b$ | rad | deg |
|---|---|---|---|---|---|---|---|
| 320 | 318.6111 | 43.05556 | 16.94444 | 17.75767 | -3772.11 | -0.0106 | -0.60757 |
| 310 | 310 | 50.27027 | 19.72973 | 20.84105 | -4921.09 | -0.00813 | -0.46572 |
| 300 | 301.8421 | 57.10526 | 22.89474 | 24.40485 | -6981.36 | -0.00573 | -0.32828 |
| 290 | 294.1026 | 63.58974 | 26.41026 | 28.4403 | -11695.9 | -0.00342 | -0.19595 |
| 280 | 286.75 | 69.75 | 30.25 | 32.94334 | -32960 | -0.00121 | -0.06953 |
| 270 | 279.7561 | 75.60976 | 34.39024 | 37.91424 | 45764.43 | 0.000874 | 0.050079 |
| 260 | 273.0952 | 81.19048 | 38.80952 | 43.3573 | 14157 | 0.002825 | 0.161887 |
| 250 | 266.7442 | 86.51163 | 43.48837 | 49.28063 | 8655.076 | 0.004622 | 0.264796 |
| 240 | 260.6818 | 91.59091 | 48.40909 | 55.69611 | 6408.454 | 0.006242 | 0.357626 |
| 230 | 254.8889 | 96.44444 | 53.55556 | 62.61938 | 5219.147 | 0.007664 | 0.43912 |
| 220 | 249.3478 | 101.087 | 58.91304 | 70.06988 | 4511.848 | 0.008866 | 0.507959 |
| 210 | 244.0426 | 105.5319 | 64.46809 | 78.07103 | 4072.331 | 0.009822 | 0.562781 |
| 200 | 238.9583 | 109.7917 | 70.20833 | 86.65045 | 3805.711 | 0.010511 | 0.602208 |
| 190 | 234.0816 | 113.8776 | 76.12245 | 95.84028 | 3667.695 | 0.010906 | 0.62487 |
| 180 | 229.4 | 117.8 | 82.2 | 105.6776 | 3641.083 | 0.010986 | 0.629437 |
| 170 | 224.902 | 121.5686 | 88.43137 | 116.2047 | 3728.619 | 0.010728 | 0.61466 |
| 160 | 220.5769 | 125.1923 | 94.80769 | 127.4703 | 3955.481 | 0.010113 | 0.579407 |
| 150 | 216.4151 | 128.6792 | 101.3208 | 139.5295 | 4384.559 | 0.009123 | 0.522705 |
| 140 | 212.4074 | 132.037 | 107.963 | 152.4452 | 5164.295 | 0.007745 | 0.443784 |
| 130 | 208.5455 | 135.2727 | 114.7273 | 166.2892 | 6699.06 | 0.005971 | 0.342112 |
| 120 | 204.8214 | 138.3929 | 121.6071 | 181.1431 | 10540.25 | 0.003795 | 0.217436 |

In this Working Example, focal length f1 = 370 mm, f2 = 310 mm and overall length TL = 380 mm. In other words, f1 ≠ f2, and TL/f1 = 1.027 > 0.8. Based on these conditions, the axial positions of at least one of lens groups 118a and 118b is adjusted, and focal length $f_r$ of the entire system is varied approximately between 300 mm to 200 mm.

As a result, telecentricity T is approximately -0.6° at focal length $f_r$ ≈ 318 mm, changes sign at $f_r$ ≈ 275 mm, is approximately 0.63° at $f_r$ ≈ 230 mm, and is approximately 0.4° at $f_r$ ≈ 210 mm. Accordingly, it can be seen in Table 1 that system overall focal length $f_r$ in the range on the order of 200 - 300 mm (d1 = 140-300) can be used. Furthermore, under the condition of TL/f1 > 0.8, the change in telecentricity T becomes smaller as overall length TL increases.

Likewise, in illumination optical system 104 of FIG. 7, back focal length dBF is derived by the expressions below, under the condition that telecentricity T is fixed:

$$d0 = f1 + f1^2/(d1 - f1 - f2) \qquad (4a)$$

$$f_r = f1 \cdot f2/(f1 + f2 - d1) \qquad\qquad (4b)$$

$$d2 = TL - d1 - d0 \qquad\qquad (4c)$$

$$dX = f2 + f2^2/(d1 - f1 - f2) \qquad\qquad (4d)$$

$$dBF = dX - d2 \qquad\qquad (4e)$$

In expressions (4a) - (4e), dX is the deviation in the back focal length dBF.

Table 2, below sets forth calculations for expressions (4a) - (4e) for Working Example 2.

### TABLE 2 - Design Values for Working Example 2

| TL | 380 |
|----|-----|
| f1 | 360 |
| f2 | 320 |

| d1 | $f_r$ | d0 | d2 | dx | dBF |
|-----|----------|----------|----------|----------|-----------|
| 320 | 320 | 0 | 60 | 35.55556 | -24.4444 |
| 310 | 311.3514 | 9.72973 | 60.27027 | 43.24324 | -17.027 |
| 300 | 303.1579 | 18.94737 | 61.05263 | 50.52632 | -10.5263 |
| 290 | 295.3846 | 27.69231 | 62.30769 | 57.4359 | -4.87179 |

| 280 | 288 | 36 | 64 | 64 | 0 |
|---|---|---|---|---|---|
| 270 | 280.9756 | 43.90244 | 66.09756 | 70.2439 | 4.146341 |
| 260 | 274.2857 | 51.42857 | 68.57143 | 76.19048 | 7.619048 |
| 250 | 267.907 | 58.60465 | 71.39535 | 81.86047 | 10.46512 |
| 240 | 261.8182 | 65.45455 | 74.54545 | 87.27273 | 12.72727 |
| 230 | 256 | 72 | 78 | 92.44444 | 14.44444 |
| 220 | 250.4348 | 78.26087 | 81.73913 | 97.3913 | 15.65217 |
| 210 | 245.1064 | 84.25532 | 85.74468 | 102.1277 | 16.38298 |
| 200 | 240 | 90 | 90 | 106.6667 | 16.66667 |
| 190 | 235.102 | 95.5102 | 94.4898 | 111.0204 | 16.53061 |
| 180 | 230.4 | 100.8 | 99.2 | 115.2 | 16 |
| 170 | 225.8824 | 105.8824 | 104.1176 | 119.2157 | 15.09804 |
| 160 | 221.5385 | 110.7692 | 109.2308 | 123.0769 | 13.84615 |
| 150 | 217.3585 | 115.4717 | 114.5283 | 126.7925 | 12.26415 |
| 140 | 213.3333 | 120 | 120 | 130.3704 | 10.37037 |
| 130 | 209.4545 | 124.3636 | 125.6364 | 133.8182 | 8.181818 |
| 120 | 205.7143 | 128.5714 | 131.4286 | 137.1429 | 5.714286 |

In this Working Example, focal length f1 = 360 mm, f2 = 320 mm and overall length TL = 380 mm. In other words, f1 ≠ f2 and TL/f1 = 1.056 > 0.8. Based on this condition, the axial position of first and second lens groups 118a and 118b is adjusted, and focal length $f_r$ of the entire system is varied approximately between 300 mm - 200 mm.

As a result, back focal length dBF ≈ -24.4 mm at a focal length f = 320 mm and changes sign at f = 280 mm. Further, dBF ≈16.7 mm at $f_r$ = 240 mm, and dBF ≈10.0 mm at $f_r$ ≈ 213 mm. Since an allowable deviation in back focal length dBF is on the order of ±10 mm, it can be seen from Table 2 that a range on the order of 200 - 300 mm (d1 = 140 - 300) can be used for focal length $f_r$ of the entire system.

In another preferred embodiment of the present invention, fly's eye lens 114 is axially moveable and its position is adjusted, thereby changing distance d0. In this case, it can be seen from Table 2 that relay lens system 118 can be made a zoom lens and the focal length thereof can be adjusted to a predetermined value without a deterioration in telecentricity T and without a deviation in back focal length dBF. Accordingly, with reference to FIG. 7, a preferred embodiment of the present invention includes a first fly's eye lens control device 180 connected to fly's eye lens 114, for axially moving the first fly's eye lens.

Also, the focal length of first fly's eye lens 114 may also be made variable. For example, with reference to FIG. 8, first fly's eye lens 114 of FIG. 7 can be split in two axially separated parts 114' and 114" thereby forming a variable first fly's eye lens 114v. An adjustable gap g exists between parts 114' and 114". By such a configuration, the above-described benefits of the present invention obtain without the need to prepare and employ a plurality of first fly's eye lenses 114. Thus, the focal length of variable first fly's eye lens 114v can be varied by using control device 180 as aperture diameter D of aperture stop 122 changes.

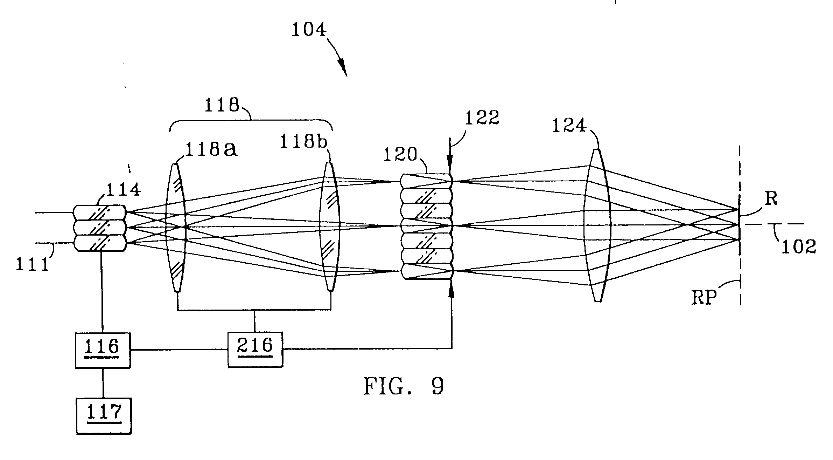

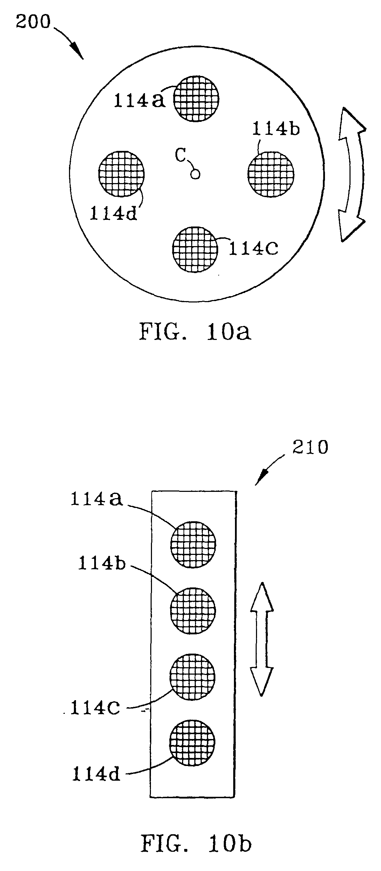

An embodiment for exchanging first fly's eye lenses 114 is now explained with reference to FIGS. 9 and 10a-10b. With reference to FIG. 9, exchange apparatus 116, for exchanging first fly's eye lens 114a with another first fly's eye lens, is connected to fly's eye lens 114a and one or more first fly's eye lenses. For example, with reference now also to FIGS. 10a-10b, exchange apparatus 116 is connected to set 117 comprising circular turret 200 having four types of first fly's eye lenses 114a-114d. Turret 200 is designed so that the desired first fly's eye lens 114 can be selected from among fly's eye lenses 114a-114d by rotating the turret by a turret drive apparatus (not shown) in exchange apparatus 116, which is attached to the center C of turret 200.

With reference now to FIG. 10b, as an alternative to circular turret 200, a slideable exchange cartridge 210 may also be employed. Cartridge 210 incorporates four types of fly's eye lenses 114a-114d aligned in its long dimension. Cartridge 210 is constituted such that it can be moved along its long direction and in a direction perpendicular to optical axis 102 of illumination optical system 104 by the drive apparatus in exchange apparatus 116, which is attached to the cartridge. The desired fly's eye lens is then selected from among fly's eye lenses 114a -114d arranged thereon.

Turret 200 and cartridge 210 may include any reasonable number of first fly's eye lenses 114 greater than two.

With reference again to FIG. 9, exchange apparatus 116 is connected to and controlled by a control apparatus 216 programmed to select an appropriate first fly's eye lens 114 in accordance with the aperture diameter D of aperture stop 112 that provides the desired value for the illumination coherence $\sigma$. Exchange apparatus may also control the focal length ff1 of the variable focal length fly's eye lens 114v (see FIG. 8). In addition, control apparatus 216 is also connected to relay lens system 118 and controls the axial movement of first and second lens groups 118a and 118b in accordance with the selected first fly's eye lens 114 and aperture diameter D of aperture stop 122, as described above. Control apparatus 216 is also preferably connected to aperture stop 122 to set the aperture diameter D in conjunction with selecting the appropriate fly's eye lens 114.

Thus, with continuing reference to FIG. 9, second fly's eye lens 120 receives light via relay lens system 118 from a plurality of secondary light source images formed by first fly's eye lens 114. Fly's eye lens 120 then forms a plurality of light source images that illuminate reticle R via condenser lens 124. Aperture diameter D of aperture stop 122, arranged proximate exit surface 120s of second fly's eye lens 120, is then adjusted. Then, a predetermined first fly's eye lens 114 from a set 117 comprising a plurality of first fly's eye lenses is selected and arranged in light beam 111 such that the set aperture diameter D is filled with a light beam of minimum diameter. In other words, substantially no light is blocked by aperture stop 122 and the illumination intensity passing through the aperture stop and incident on reticle R is substantially the maximum value possible. In maximizing the illumination intensity on reticle R, the magnification of a relay lens system 118 is adjusted, wherein the relationship f1 ≠ f2 holds.

While the present invention has been described in connection with various embodiments and working examples, it will be understood that it is not so limited. On the contrary, it is intended to cover all alternatives, modifications and equivalents as may be included within the spirit and scope of the invention as defined in the appended claims.

**Claims**

1. An illumination optical system for illuminating an object plane, the system comprising, along an optical axis:

   a) a light source for generating a light beam;
   b) a first optical integrator having an incident surface and an exit surface;
   c) a second optical integrator having an incident surface and an exit surface;
   d) a relay lens system disposed between said first and second optical integrators and comprising a first lens group with a focal length f1 and a second lens group with a focal length f2, wherein f1 ≠ f2, and wherein said relay lens system has a variable focal length and is designed such that said incident surfaces are substantially conjugate and said exit surfaces are substantially conjugate; and
   e) a condenser lens proximate said second optical integrator exit surface for condensing light from said second optical integrator onto the object plane.

2. An illumination optical system according to claim 1, wherein TL is the distance between said exit surface of said first optical integrator and said incident surface of said second optical integrator, and wherein the following condition is satisfied:

$$TL/f1 \geq 0.8.$$

3. An illumination optical system according to claim 1, wherein said first optical integrator has a variable focal length.

4. An illumination optical system according to claim 1, wherein said first optical integrator is axially moveable.

5. An illumination optical system according to claim 1, further comprising a plurality of optical integrators, each having different focal lengths, wherein said first optical integrator is exchangeably arranged and selectable from said plurality of first optical integrators.

6. An illumination system according to claim 5, further comprising a turret, wherein said plurality of optical integrators are supported by said turret.

7. An illumination optical system according to claim 5, further comprising a cartridge for supporting said plurality of first optical integrators.

8. An illumination system according to claim 5, further including an exchange apparatus connected to said plurality of optical integrators for exchanging one of said plurality of first optical integrators with another of said plurality of optical integrators.

9. An illumination system according to claim 8, further including a control device connected to said exchange apparatus for controlling said exchange apparatus.

10. An illumination apparatus according to claim 9, further including an aperture stop having a variable aperture diameter and arranged proximate said second optical integrator exit surface and connected to said control device such that said diameter can be controlled to correspond to the focal of at least one of said plurality of optical integrators.

11. An illumination apparatus according to claim 10, wherein said control device is connected to said relay lens system so as to vary said variable focal length to illuminate said second optical integrator incident surface over a region corresponding to said aperture stop diameter.

12. An projection exposure apparatus capable of exposing a mask with a pattern onto a photosensitive substrate, the apparatus comprising, along an optical axis:

   a) a light source for generating a light beam;
   b) a first optical integrator having an incident surface and an exit surface;
   c) a second optical integrator having an incident surface and an exit surface;
   d) a relay lens system disposed between said first and second optical integrators and comprising a first lens group with a focal length f1 and a second lens group with a focal length f2, wherein f1 ≠ f2, and wherein said relay lens system has a variable focal length and is desired such that said incident surfaces are substantially conjugate and said exit surfaces are substantially conjugate;
   e) a condenser optical system for condensing light from said second optical integrator onto the mask; and
   f) a projection lens arranged between the mask and the photosensitive substrate.

13. A projection exposure apparatus according to claim 12, wherein TL is the distance between said exit surface of said first optical integrator and said incident surface of said second optical integrator, and wherein the following condition is satisfied:

$$TL/f1 \geq 0.8.$$

14. A projection exposure apparatus according to claim 12, further comprising a plurality of optical integrators, each having different focal lengths, wherein said first optical integrator is selectable from said plurality of first optical integrators.

15. A projection exposure apparatus according to claim 14, further comprising a turret, wherein said plurality of first optical integrators are supported by said turret.

16. A projection exposure apparatus according to claim 14, further comprising a cartridge for supporting said plurality of first optical integrators.

17. A projection exposure apparatus according to claim 14, farther including an exchange apparatus connected to said plurality of optical integrators, for exchanging one of said plurality of optical integrators with another of said plurality of optical integrators.

18. An illumination system according to claim 17, further including a control device connected to said exchange apparatus for controlling said exchange apparatus.

19. An illumination apparatus according to claim 18, further including an aperture stop having a variable aperture diameter and arranged proximate said second optical integrator exit surface and connected to said control device such that said diameter can be controlled to correspond to the focal length of at least one of said plurality of optical integrators.

20. An illumination apparatus according to claim 19, wherein said control device is connected to said relay lens system so as to vary said relay lens system variable focal length to illuminate said second optical integrator incident surface over a region corresponding to said aperture stop diameter.

21. A method of substantially maintaining illumination intensity at an object plane while changing the illumination coherence, the method comprising the steps of:

   a) transmitting light through an incident surface of a first optical integrator having a first focal length and forming a plurality of secondary light sources;
   b) relaying light from each of said secondary light sources to be incident over a first region of an incident surface of a second optical integrator using a relay lens system having a variable focal length, thereby forming a plurality of tertiary light sources within an aperture stop having a first diameter;
   c) condensing light from each of said tertiary light sources to be incident the object plane at a predetermined illumination intensity;
   d) changing the illumination coherence by changing the diameter of the aperture stop to a second diameter; and
   e) varying said relay lens system focal length to illuminate a second region of said incident surface of said second optical integrator corresponding to said second diameter so as to subsequently maintain said predetermined intensity at the object plane.

22. A method according to claim 21, further including, in said step d), exchanging said first optical integrator with another first optical integrator having a second focal length.

23. A method according to claim 21, wherein said first focal length is variable, and said step e) further includes the step of varying said first focal length.

24. A method according to claim 21, wherein said first optical integrator is axially moveable, and said step e) further includes the step of axially moving said first optical integrator.

25. A method according to claim 21, wherein said first optical integrator is exchangeably arranged, and wherein said step e) further includes the step of exchanging said first optical integrator with another first optical integrator having a second focal length.

26. A method of patterning a photosensitive substrate, comprising the steps of:

   a) relaying light from each of a plurality of secondary light sources to be incident over a first region of an incident surface of an optical integrator using a variable focal length relay lens system, thereby forming a plurality of tertiary light sources within an aperture stop having a first diameter;
   b) condensing light from each of said tertiary light sources to be incident a reticle plane at a predetermined illumination intensity;
   c) providing and inserting at said reticle plane a first reticle having a first pattern;
   d) projecting a first image of said first reticle pattern on the photosensitive substrate and forming a first substrate pattern thereon;
   e) changing illumination coherence by changing the diameter of said aperture stop to a second diameter;
   f) varying said variable focal length of said relay lens system to illuminate a second region of said incident surface of said second optical integrator corresponding to said second diameter, thereby substantially maintaining said predetermined intensity at said reticle plane;
   g) removing said first reticle and providing and inserting at said reticle plane a second reticle having a second pattern; and
   h) projecting a second image of a second reticle pattern on the photosensitive substrate and forming a second substrate pattern thereon.

27. A method of patterning a photosensitive substrate, the method comprising the steps of:

a) relaying light from each of a plurality of secondary light sources to be incident over a first region of an incident surface of an optical integrator using a variable focal length relay lens system, thereby forming a plurality of tertiary light sources within an aperture stop having a first diameter;

b) condensing light from each of said tertiary light sources to be incident a reticle plane at a predetermined illumination intensity;

c) providing and inserting at said reticle plane a reticle having a pattern;

d) projecting a first image of said reticle pattern on the photosensitive substrate and forming a first substrate pattern thereon;

e) changing illumination coherence by changing the diameter of said aperture stop to a second diameter;

f) varying said variable focal length of said relay lens system to illuminate a second region of said incident surface of said optical integrator corresponding to said second diameter so as to maintain illumination of said reticle plane at said predetermined intensity; and

g) projecting a second image of said reticle pattern on the photosensitive substrate and forming a second substrate pattern thereon.

28. A method of patterning a photosensitive substrate, the method comprising:

a) relaying light from each of a plurality of secondary light sources using a variable focal length relay lens system and forming a first plurality of tertiary light sources within an aperture stop having a first diameter;

b) condensing light from each light source in said first plurality of tertiary light sources so as to be incident, in an overlapping manner and at a predetermined intensity, a reticle with a pattern, thereby projecting a first image of said reticle pattern on the photosensitive substrate and forming a first substrate pattern thereon;

c) changing illumination coherence by changing the diameter of said aperture stop to a second diameter;

d) varying said variable focal length of said relay lens system and forming a second plurality of tertiary images within said second aperture stop so as to maintain said predetermined intensity on said reticle; and

e) condensing light from each light source in said second plurality of tertiary light sources so as to be incident, in an overlapping manner at substantially said predetermined intensity, said reticle, thereby projecting a second image of said reticle pattern on the photosensitive substrate and forming a second substrate pattern thereon.

29. A method of patterning a photosensitive substrate, the method comprising:

a) relaying light from each of plurality of secondary light sources using a variable focal length relay lens system and forming a first plurality of tertiary light sources within an aperture stop having a first diameter;

b) condensing light from each light source in said first plurality of tertiary light sources so as to be incident, in an overlapping manner and at a predetermined intensity, a reticle plane containing a first reticle with a first pattern, thereby projecting a first image of said first pattern on the photosensitive substrate and forming a first substrate pattern thereon;

c) changing illumination coherence by changing the diameter of said aperture stop to a second diameter;

d) varying said variable focal length of said relay lens system and forming a second plurality of tertiary images within said second aperture stop so as to maintain said predetermined intensity at said reticle plane; and

e) condensing light from each light source in said second plurality of tertiary light sources so as to be incident, in an overlapping manner at substantially said predetermined intensity, a second reticle with a second pattern arranged in said reticle plane, thereby projecting a second image of said second pattern on the photosensitive substrate and forming a second substrate pattern thereon.

30. An optical integrator system comprising:

a) a first optical integrator having an incident surface and an exit surface;

b) a second optical integrator having an incident surface and an exit surface;

c) a relay lens system disposed between said first and second optical integrators and comprising a first lens group with a focal length f1 and a second lens group with a focal length f2, wherein f1 ≠ f2, and wherein said relay lens system has a variable focal length and is designed such that said incident surfaces are substantially conjugate and said exit surfaces are substantially conjugate.

31. An optical integrator system according to claim 30, wherein TL is the distance between said exit surface of said first optical integrator and said incident surface of said second optical integrator, and wherein the following condition is satisfied:

TL/f1 ≥ 0.8.

**32.** An optical integrator system according to claim 30, wherein said first optical integrator has a variable focal length.

**33.** An optical integrator system according to claim 30, wherein said first optical integrator is axially moveable.

**34.** An optical integrator system according to claim 30, further comprising a plurality of optical integrators, each having different focal lengths, wherein said first optical integrator is exchangeably arranged and selectable from said plurality of first optical integrators.

**35.** An optical integrator system according to claim 34, further comprising a turret, wherein said plurality of optical integrators are supported by said turret.

**36.** An optical integrator system according to claim 34, further comprising a cartridge for supporting said plurality of first optical integrators.

**37.** An optical integrator system according to claim 34, further including an exchange apparatus connected to said plurality of optical integrators for exchanging one of said plurality of first optical integrators with another of said plurality of optical integrators.

**38.** An optical integrator system according to claim 37, further including a control device connected to said exchange apparatus for controlling said exchange apparatus.

FIG. 1
PRIOR ART

FIG. 2
PRIOR ART

FIG. 3a

FIG. 3b

FIG. 3c

FIG. 4a

FIG. 4b

20

FIG. 5

FIG. 6a

FIG. 6b

FIG. 7

FIG. 8

FIG. 9

FIG. 10a

FIG. 10b